# EUROPEAN PATENT SPECIFICATION

(11) **EP 0 321 238 B1**
(45) Date of publication and mention of the grant of the patent: **02.03.1994**
(21) Application number: 88311868.9
(22) Date of filing: 15.12.1988
(51) Int. Cl.: H01L 21/60

(54) **Electrode connecting method**
Verfahren zum Verbinden einer Elektrode
Procédé pour la connexion d'une électrode

(30) Priority: 17.12.1987 JP 319443/87
(43) Date of publication of application: 21.06.1989
(73) Proprietor: MATSUSHITA ELECTRIC INDUSTRIAL CO., LTD., Kadoma-shi, Osaka-fu, 571 (JP)
(72) Inventor: Hatada, Kenzo, Katano-shi Osaka (JP); Fujimoto, Hiroaki, Hirakata-shi Osaka (JP)
(74) Representative: Crawford, Andrew Birkby

(56) References cited:
- PATENT ABSTRACTS OF JAPAN, vol. 12, no. 174 (E-612)[3021], 24th May 1988; & JP-A-62 281 360
- PATENT ABSTRACTS OF JAPAN, vol. 10, no. 133 (E-404)[2190], 17th May 1986; & JP-A-60 262 430

## Description

This invention relates to a method of connecting a semiconductor chip to a wiring board and more particularly to a method of connecting the semiconductor device face down, and using an insulating resin.

It is known to connect the semiconductor face down on a circuit substrate, by forming a solder bump on the electrode of the semiconductor device, and join it with the wiring electrode on the circuit substrate. In this method, since the electrode of the semiconductor device and the electrode of the circuit substrate are fixed by solder bump, when a thermal or mechanical stress acts on the semiconductor device or circuit substrate, the stress is entirely concentrated on the junction of the solder bump, possibly resulting in breakage of the junction and lowering of the reliability.

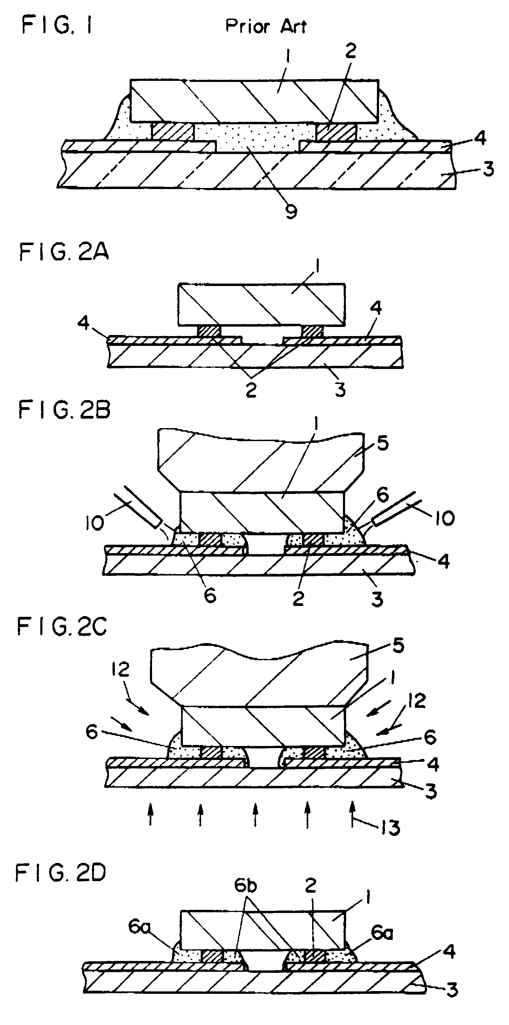

To solve these problems, as shown in FIG. 1, an electrode 2 is disposed on a semiconductor device 1, and while positioning a wiring electrode 4 of a circuit substrate 3 with this electrode 2, an insulating resin is inserted between the semiconductor device 1 and circuit substrate 3, and the insulating resin is stiffened while pressing the semiconductor device 1. By making use of the contracting force of the insulating resin at the time of stiffening, the electrode 2 of the semiconductor device 1 is pressed against the wiring electrode 4 of the circuit substrate 2, thereby obtaining an electric connection (for example, as disclosed in U.S.P. 4,749,120).

In the conventional fabrication process shown in FIG. 1, insulating resin is placed between the electrode 2 of the semiconductor device 1 and the electrode 4 of the circuit substrate 3, and the device and substrate are directly pressed together to stiffen the resin. Accordingly, an electric connection of the two electrodes will not be obtained unless the intervening resin between the two electrodes 2, 4 is removed, and therefore, the semiconductor device or the circuit substrate is pressed with a high pressure. As a result, a bending stress is formed on the semiconductor device or circuit substrate, and the connection between the electrodes is partially impaired, and it is difficult to obtain a favourable connection. Besides, when the pressure is high, there is a risk of destroying the semiconductor device, and this is particularly obvious in fragile devices other than si, such as GaAs.

Further, since the insulating resin is applied on the entire surface of the semiconductor device 1, when the semiconductor device or circuit substrate is heated the entire insulating resin is expanded, and when this expanding force exceeds the contracting force, the electrode at the pressed part and the wiring electrode separate from each other, which often causes defective junctions.

JP-A-62 281 360 discloses a method wherein an electrode on a first substrate is positioned on an electrode on a second substrate. The substrates are pressed together and an acrylic resin is applied from the side of the second substate. The pressure then relieved after the resin has stiffened.

The present invention provides a method of connecting a semiconductor chip to a wiring board comprising the steps of
positioning a bump electrode of a semiconductor chip and an electrode of a wiring board;
pressing said bump electrode of said semiconductor chip and said electrode of wiring board together;
injecting an insulating resin from the side of said semiconductor chip so as to fill the surrounding area of contact between said bump electrode and said electrode of the wiring board at least with said insulating resin; and
relieving the pressure after the resin is stiffened.

An advantage of this invention is that there is a notable lowering of the connection resistance between electrodes by connecting due to no insulating resin being inserted between the electrodes of semiconductor device and circuit substrate.

This also results in highly reliable connection without causing defective junction between electrodes due to thermal expansion of the resin.

Features and advantages of the present invention will become apparent from the following description of an embodiment thereof when taken in conjuction with the accompanying drawings, in which:-
FIG. 1 is a sectional view of a semiconductor device connected by means of an insulating resin in a prior art; and
FIG. 2 is a process sectional view showing connecting steps of one of the embodiments of this invention.

Referring now to FIG. 2, an embodiment of the invention is described below. First, an electrode 2 of a semiconductor device 1 such as semiconductor integrated circuit device and an electrode 4 of a circuit substrate 3 are positioned (FIG. 2A), and with the electrodes 2 and 4 contacting each other and a pressure is applied between them by means of a pressure tool 5. A light-stiffening insulating resin 6 is injected from the side of the semiconductor device, at least in the gap between the semiconductor device 1 and circuit substrate 3. Actually, along the peripheral margin of the semiconductor device 1, the resin is poured in by using a tool 10 such as a dispenser (FIG. 2B). Afterwards light having a wavelength suitable for stiffening the light-stiffening insulating resin 6 (for about 10 to 30 seconds at 40 mW/ cm²) is emitted. For example, in the case of an ultra-violet ray stiffening type resin, ultraviolet rays 12, 13 are emitted from the side of the circuit substrate or from the side of semiconductor device to stiffen the light-stiffening resin 6 (FIG. 2C). Immediately before this light stiffening, it may be also possible to form a further pressurized state. For example, when injecting the resin 6, a pressure of 5 g is applied per electrode, and a pressure of 10 to 70 g is applied when irradiating. After stiffening, this pressure is removed (FIG. 2D). As a result, the electrodes 2, 4 are electrically connected with each other, and the semiconductor device 1 and circuit substrate 3 are mutually adhered and fixed by the resin 6 at the same time. The electrodes 2 of the semiconductor device is an Au bump of, for example, 5 to 20µm. Or this bump may be formed on the electrode 4 of the circuit substrate.

The state of the light-stiffened resin 6 after stiffening is present, as shown in FIG. 2D, at least in the peripheral area 6a of the semiconductor device 1, and the adjacent part 6b of the electrodes 2, 4.

As the light-stiffening resin 6, acrylic or epoxy resins stiffened by light only may be used, or resins stiffened by both light and heat may be used. For example, when the circuit substrate is opaque, light is directed on to the resin from the sides of the semiconductor device while in pressurized state to stiffen the peripheral resin of the semiconductor device, and the resin not illuminated with the light in the vicinity of the electrode may be stiffened at ordinary temperature or by heating.

Results of a practical experiment are described below.

The sample was a semiconductor device 1 having 3000 Au electrodes 2 formed on a 7 mm square Si chip at intervals of 100µm. The height of the Au electrodes 2 was 5µm, and the circuit substrate 3 was a glass plate, and the wiring electrode 4 was composed of Cr-Au. The test was a thermal impact test which was most susceptible to thermal stress, which was conducted in a condition of -55°C/+150°C.

As a result, in the conventional method shown in FIG. 1, a junction failure occurred in 520 cycles, while in the method of this invention (FIG. 2D) there was no failure even after 2500 cycles.

It is hence known that the composition of this invention is very effective against thermal stress.

Besides, the contact resistance in the initial connecting point is 4 to 10 mohms in the prior art when the contact area between the electrodes is µm², whereas it is 0.2 to 0.6 mohm in this invention, being more than one order of magnitude smaller. Furthermore, as a result of connecting 1200 LSI chips, the LSI chip breakage rate when connecting, which was 0.35% in the prior art, was almost 0% in this invention.

It is moreover evident that this invention may be applied not only to connection of semiconductor devices but also to that of two circuit substrates having electrodes.

This invention brings about, among others, the following benefits.
1. According to the method of this invention, since the insulating resin is injected while the semiconductor device and substrate are in a pressurized state, the resin does not intervene between the electrodes of the semiconductor and circuit substrate, so that the contact resistance between the electrodes may be dramatically decreased.
2. Besides, since the resin is introduced while the semiconductor device and substrate are in the pressurized state, the required pressure is about 1/3 to 1/2 that of the prior art. Therefore, since the pressure applied to the semiconductor device is small, the semiconductor will not be broken, and this invention may be applied to semiconductor devices made of fragile compounds such as GaAs and InP, aside from Si.
3. In the fabricating method of this invention, since the insulating resin is present only on the periphery of the semiconductor device and in the vicinity of electrodes, the forces acting on the joined electrodes is small, so that a high reliability may be realized.
4. Since the resin is injected after pressing the electrodes together, the characteristics of the semiconductor device may be measured in the pressurized state, and the semiconductor device may be readily replaced if defective. Also because resin does not deposit on the circuit substrate, the process requirement replacement is extremely short.
5. The injected resin is present on the periphery of the semiconductor device and in the vicinity of the electrodes, and therefore, when the circuit substrate is opaque, when light is emitted from the back side of the semiconductor device, the entire resin can be stiffened by making use of the light turning around from the back.

## Claims

1. A method of connecting a semiconductor chip to a wiring board comprising the steps of
positioning a bump electrode (2) of a semiconductor chip (1) and an electrode (4) of a wiring board (3);
pressing said bump electrode (2) of said semiconductor chip and said electrode (4) of wiring board together;
injecting an insulating resin (6) from the side of said semiconductor chip so as to fill the surrounding area of contact between said bump electrode and said electrode of the wiring board at least with said insulating resin; and
relieving the pressure after the resin (6) is stiffened.

2. A method according to claim 1, wherein the resin is stiffened by light (12) or heat (10).

## Patentansprüche

1. Ein Verfahren zum Verbinden eines Halbleiter-Chip mit einer Verdrahtungsplatte, das die Schritte umfaßt
Positionieren einer Anschlußelektrode (2) eines Halbleiter-Chip (1) und einer Elektrode (4) einer Verdrahtungsplatte (3);
Zusammendrücken der genannten Anschlußelektrode (2) des genannten Halbleiter-Chip und der genannten Elektrode (4) der Verdrahtungsplatte;
Einspritzen eines isolierenden Kunstharzes (6) von der Seite des genannten Halbleiter-Chip, um den Umgebungsbereich des Kontaktes zwischen der genannten Anschlußelektrode und der genannten Elektrode der Verdrahtungsplatte zumindest mit dem genannten isolierenden Kunstharz zu füllen; und
Aufheben des Druckes nachdem das Kunstharz (6) gehärtet ist.

2. Ein Verfahren gemäß Anspruch 1, bei dem das Kunstharz durch Licht (12) oder Wärme (10) gehärtet wird.

## Revendications

1. Procédé de connexion d'une pastille à semi-conducteur à une carte de câblage, comprenant les étapes suivantes :
le positionnement d'une électrode à saillie (2) d'une pastille semi-conductrice (1) et d'une électrode (4) d'une carte de câblage (3),
l'application d'une pression de rapprochement de l'électrode à saillie (2) de la pastille semi-conductrice et de l'électrode (4) de la carte de câblage,
l'injection d'une résine isolante (6) par le côté de la pastille semi-conductrice afin que la zone voisine de contact comprise entre l'électrode à saillie et l'électrode de la carte de câblage au moins soit remplie de résine isolante, et
la suppression de la pression appliquée après le durcissement de la résine (6).

2. Procédé selon la revendication 1, dans lequel la résine est durcie par projection de lumière (12) ou de chaleur (10).
